# EUROPÄISCHE PATENTSCHRIFT

(11) **EP 0 588 268 B1**
(45) Veröffentlichungstag und Bekanntmachung des Hinweises auf die Patenterteilung: **24.04.1996**
(21) Anmeldenummer: 93114616.1
(22) Anmeldetag: 11.09.1993
(51) Int. Cl.: H01R 9/07

(54) **Leiterbahnen-Verbindung**
Conducting path connection
Connexion pour des voies conductrices

(30) Priorität: 15.09.1992 DE 9212403 U
(43) Veröffentlichungstag der Anmeldung: 23.03.1994
(73) Patentinhaber: Valeo Borg Instruments Verwaltung GmbH, D-75196 Remchingen (DE)
(72) Erfinder: Barth, Manfred, D-75323 Wildbad (DE); Obergfell, Werner Ernst, Dipl.-Ing., D-78126 Königsfeld-Burgberg (DE); Arheit, Thomas, D-76356 Weingarten (DE); Renken, Toni, Dipl.-Ing., D-75196 Remchingen (DE)
(74) Vertreter: COHAUSZ HASE DAWIDOWICZ & PARTNER

(56) Entgegenhaltungen:
- GB-A- 2 219 443
- US-A- 3 476 901
- IBM TECHNICAL DISCLOSURE BULLETIN Bd. 31, Nr. 5, Oktober 1988, ARMONK,NY,USA Seiten 296 - 297

## Beschreibung

Die Erfindung betrifft eine Leiterbahnen-Verbindung gemäß dem Oberbegriff des Anspruches 1.

Eine derartige Verbindung ist aus dem DE-GM 18 80 761 bekannt. Dort ist vorgesehen, einzelne Drähte in einen flexiblen Isolierstoff-Träger einzufassen, aus dem sie an beiden Stirnseiten so weit hervorstehen, daß sie jeweils am Orte zweier zu verbindender Leiterbahnen durch Bohrungen in deren Trägerplatten hindurchgesteckt und wie Bauelemente verlötet werden können, um eine flexible Überbrückung zwischen einander benachbarten starren Leiterbahnen-Trägern zu schaffen, die beispielsweise gegeneinander verschwenkbar bleiben bzw. in unterschiedlichen Ebenen oder Winkeln montiert werden sollen. Problematisch ist allerdings der Aufwand für die Herstellung einer solchen lötbaren Überbrückung in Form von individuellen, nebeneinander eingegossenen Drähten, zumal das isolierende Umhüllungsmaterial in Hinblick auf den Lötvorgang an seinen beiden Stirnenden, aus denen die Drähte austreten, hitzebeständig sein muß. Die am preiswertesten verfügbaren und wegen ihrer günstigen mechanischen Eigenschaften etwa als flexible Leiterbahnenträger häufig angewandten Polyesterfolien sind für eine solche zu verlötende Überbrückung wegen zu großer Wärmeempfindlichkeit aber nicht geeignet.

Eine starre Laschen-Überbrückung, wie sie etwa aus der DE-OS 40 27 214 bekannt ist, würde sich zwar grundsätzlich zwischen starren Trägern realisieren lassen; aber nicht zwischen einem starren und einem flexiblen Träger, wenn der flexible Träger selbst als Verbindungsleitung zu einem weiteren starren Träger führt, damit dieser in beliebiger anderer Positionierung bezüglich des ersten starren Trägers oder sogar beweglich bezüglich dessen angeordnet werden kann. Gerade bei räumlich beschränkten Einbaubereichen ist es nämlich häufig nicht möglich, eine einzige Trägerplatte hinreichend groß auszulegen, um darauf alle erforderlichen Komponenten einer Schaltung anzuordnen. Wenn aber Schaltungsteile aus Raumgründen auf verschiedene Trägerplatten verteilt werden müssen, dann kann es leicht vorkommen, daß diese im Betrieb, etwa im Einbaubereich hinter dem Armaturenbrett eines Kraftfahrzeuges, aufgrund unterschiedlicher Montageorte unterschiedliche mechanische Beanspruchungen erfahren und deshalb über eine einerseits elektrisch und mechanisch sichere aber andererseits flexible Verbindung miteinander verschaltet werden müssen.

Deshalb ist es Aufgabe vorliegender Erfindung, eine Leiterbahnen-Verbindung gattungsgemäßer Art dahingehend weiterzubilden, daß sie aus preiswerten Materialen einfach und sicher erstellbar ist und zugleich auch die Möglichkeit eröffnet, für Test- und Austauschanforderungen als wieder lösbare Verbindung ausgelegt sein zu können.

Diese Aufgabe wird bei einer Leiterbahnen-Verbindung gattungsgemäßer Art im wesentlichen dadurch gelöst, daß sie nach dem Kennzeichnungsteil des Anspruches 1 ausgelegt ist.

Gemäß dieser Lösung kann auf eine herkömmliche, in der Praxis bewährte und äußert preisgünstig verfügbare Polyesterfolie als Träger für.die Leiterbahnen einer flexiblen Leiterplatten-Überbrückung zurückgegriffen werden; wobei zur Vermeidung von Lötvorgängen die jeweilige Verbindung zwischen dem flexiblen und dem starren Leiterbahnen-Träger sowohl in mechanischer wie auch in elektrischer Hinsicht mittels eines Isolierstoff-Verbinders erfolgt, der als Halter von Brücken ausgebildet ist, welche als metallisch leitende Kontaktpaare die miteinander zu verbindenden Leiterbahnen erfassen. Dabei können diese Brücken in zwei Ebenen wirken, die der Leiterbahnen-Kaschierung des flexiblen Trägers und, jener abgewandt, des starren Trägers zugeordnet sind; oder die Metallklammer-Brücken liegen praktisch in einer Ebene, wobei die unkaschierte Seite des flexiblen Trägers auf der kaschierten Oberfläche des starren Trägers ruht. Der Halter für die Brücken kann verdrehbar sein, wobei dann die freien kontaktgebenden Schenkel der einzelnen Brücken radial sternförmig von der Drehachse fortweisen. Bei einem linear verschiebbaren Halter dagegen sind die einzelnen den Leiterpaaren zugeordneten Brücken in Verschieberichtung nebeneinander angeordnet, wobei auch nach entgegengesetzten Richtungen weisende Brücken vorgesehen sein können.

Wenn die Brücken zwei Kontaktierungsebenen aufweisen, dann sind in den Leiterbahnen-Trägern Aussparungen vorzusehen, um einen der Brücken-Schenkel beim Einführen des Halters bis in die gegenüberliegende Ebene absenken zu können, ehe die elektrische und mechanische Verbindung des zugeordneten, seitlich gegen die Aussparungen versetzten Paares von Leiterbahnen durch eine Dreh- oder Verschiebebewegung des Halters hergestellt wird. Wenn dagegen die Schenkel der U-förmigen Brücken im wesentlichen in einer Ebene liegen, dann brauchen lediglich am Stirnrand des flexiblen Leiterplatten-Trägers über der jeweils zugeordneten starren Leiterbahn Einschnitte vorgesehen zu sein, damit die starre Leiterbahn hier durch den flexiblen Träger hindurch zugänglich ist.

Zusätzliche Alternativen und Weiterbildungen sowie weitere Merkmale und Vorteile der Erfindung ergeben sich aus den weiteren Ansprüchen, und, auch unter Berücksichtigung der Darlegungen in beiliegender Kurzfassung, aus nachstehender Beschreibung von in der Zeichnung unter Beschränkung auf das Wesentliche abstrahiert aber angenähert maßstabsgerecht skizzierten bevorzugten Realisierungsbeispielen zur erfindungsgemäßen Lösung. In der Zeichnung zeigt:
- Fig. 1: einen verdrehbaren Verbinder in Draufsicht,
- Fig. 2: den Verbinder nach Fig. 1 im Querschnitt und
- Fig. 3: einen in Längsrichtung verschiebbaren Verbinder in Draufsicht.

Ein flexibler Leiterbahnen-Träger 11 ist mittels eines Verbinders 12 mechanisch und elektrisch an einen starren Leiterbahnen-Träger 13 angeschlossen. Die Leiterbahnen 14 des flexiblen Trägers 11 dienen der Verdrahtung des starren Trägers 13 mit einem anderen (in der Zeichnung nicht dargestellten) starren Träger, der beispielsweise in einer anderen Ebene und/oder in anderer Orientierung als der Träger 13 angeordnet ist. Die Leiterbahnen 15 des starren Trägers 13 dienen der Verschaltung von Kontakt- und Bauelementen, die vom starren Träger 13 gehaltert werden (in der Zeichnung nicht dargestellt).

Der elektrischen Kontaktierung eines zugehörigen Leiterbahnen-Paares 14-15 dient jeweils eine metallene Brücke 16, die formschlüssig oder kraftschlüssig aber ohne Einsatz von Klebemitteln an einem Isolierstoff-Halter 17 befestigt ist, etwa eingeklemmt oder eingerastet in das Ende einer an der Peripherie des Halters 17 ausgesparrten oder ausgearbeitenen Halterungsnut 18. Durch die Vermeidung einer Klebe-Montage ist eine hohe Kontaktsicherheit gewährleistet, die sonst durch das Ausgasen von Klebstoff-Bestandteilen beeinträchtigt werden könnte.

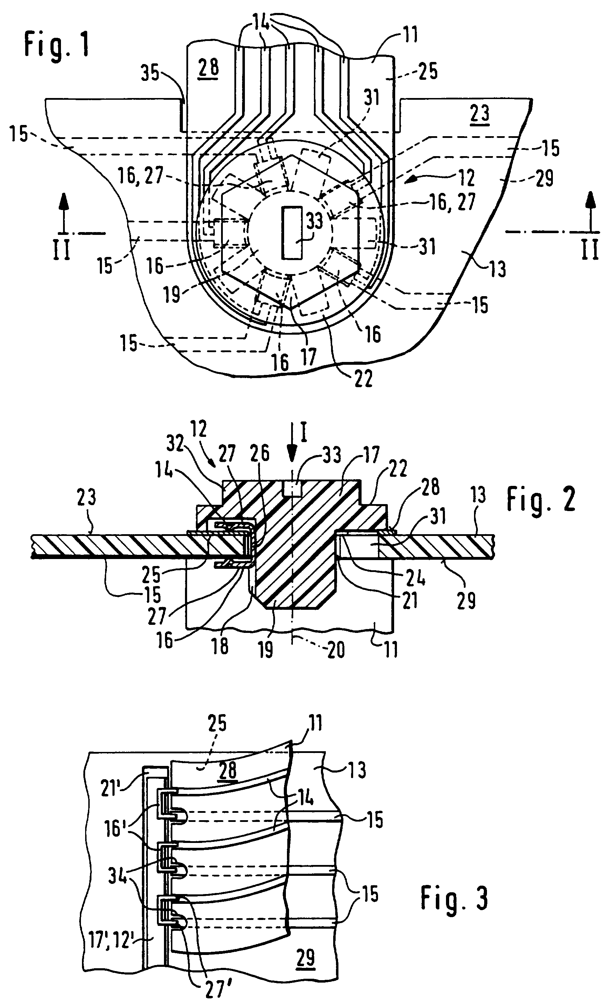

Im Falle eines verdrehbaren Verbinders 12 greift sein Halter 17 mit einem Zapfen 19, in dessen Mantelfläche parallel zur Drehachse 20 die Halterungsnuten 18 für Brücken 16 ausgebildet sind, durch eine Führungsöffnung 21 im starren Träger 13 hindurch, bis eine flanschförmige Verbreitung 22 am gegenüberliegenden Ende des Zapfens 19 gegen die unkaschierte Aufnahmeseite 23 anliegt. Jedoch ist zwischen dieser und der Zapfen-Verbreitung 22 der flexible Träger 11 mit konzentrischer Durchgangsöffnung 24 angeordnet, und zwar so, daß seine unkaschierte Auflageseite 25 auf der Leiterplatten-Aufnahmeseite 23 ruht. Weil dementsprechend die Kaschierung der Leiterbahnen 15, 14 auf den voneinander abgewandten Oberflächen gelegen ist, weist die Brücke 16 für diesen Aufbau die Form einer U-förmigen Klammer auf, deren Joch 26 in der Halterungsnut 18 parallel zur Drehachse 20 ruht, während die Schenkel 27 davon radial fort nach außen ragen, und zwar die mit den Leiterbahnen 14 bzw. 15 kaschierten Oberflächen 28 bzw. 29 übergreifen (wie in Fig. 2 dargestellt). In der Nähe der freien Enden der Schenkel 27 sind aufeinander zuweisende Kontaktbuckel ausgebildet, damit die Kontaktierung der Brücke 16 zu einerseits den Leiterbahnen 14 des flexiblen Trägers 11 und anderseits den Leiterbahnen 15 des starren Trägers 13 im Interesse geringen Übergangswiderstandes einen möglichst hohen spezifischen Druck ergibt.

Die bezüglich der Drehachse 20 radial vorstehenden aber am Verschwenken durch die Aufnahme im Halter 17 gehinderten Brücken 16 tauchen beim Einsetzen des Verbinders 12 mit ihrem jeweils einer starren Leiterbahn 15 zugeordneten Schenkel 27 durch radial von den Öffnungen 21, 24 fortweisende, miteinander fluchtende Aussparungen 31 in den Trägern 13 hindurch. Einer solchen Aussparung 31 gegenüber winkelmäßig versetzt endet an der Peripherie der Führungsöffnung 21 die zugeordnete Leiterbahn 15 des starren Trägers 13. Darüber endet auf dem flexiblen Träger 11 deren Leiterbahn 14. Nach dem Einsetzen des mit der entsprechenden Brücke 16 bestückten Halters 17 braucht dieser also lediglich um den entsprechenden Winkel aus der Radialrichtung der Aussparungen 31 heraus verschwenkt zu werden, um mit seinen beiden Schenkeln 27 unter Anlage gegen das miteinander zu verbindende Leiterbahnen-Paar 14-15 die beiden Träger 11-13 achsparallel zusammenzudrücken und damit eine sowohl mechanisch wie auch elektrisch sichere Leiterbahnen-Verbindung zu ergeben.

Zur Förderung des Überganges aus der Aussparungen 31 in den Bereich des Endes der Leiterbahn 14, 15 sind die Ebenen der Schenkel 27 zweckmäßigerweise quer zu ihrer Längserstreckung etwas V-förmig angestellt, womit das Hinaufgleiten auf die mit den Leiterbahnen 14, 15 kaschierten Oberflächen 28, 29 beim Verdrehen des Halters 17 erleichtert wird. Für dessen Drehbewegung kann die kragenförmige Verbreiterung 23 als Mehrkantkopf 32 für das Ansetzen eines Schraubenschlüssels ausgebildet sein. Stattdessen oder zusätzlich kann die Verbreiterung 22 aber auch mit einem konzentrischen Schlitz 33 für das Ansetzen eines Schraubendrehers ausgestattet sein. Entgegen der zeichnerischen Darstellung in Fig. 1 kann vorgesehen sein, daß die Leiterbahnen 14, 15 dichter neben den Einführ-Aussparungen 31 enden, so daß nur ein kleiner Drehwinkel zu vollführen ist. Auch kann an wenigstens einem der Schenkel 27 der Drehrichtung entgegen ein Anschlag, etwa in Form eines abgewinkelten Lappen, ausgebildet sein, der durch Eingriff gegen die Berandung der Aussparungen 31 ein zu weites Verdrehen des Halters 17 mit seinen sternförmig vorragenden Schenkelpaaren 27-27 verhindert.

Bei der vereinfacht skizzierten Ausführungs-Variante nach Fig. 3 ist der Verbinder 12 nicht in einer konzentrischen Führungsöffnung 21 verdrehbar; vielmehr ist hier im plattenförmigen Träger 13 eine linear gestreckte Führungsöffnung 21' ausgebildet, in der ein linearer Verbinder 12' in Längsrichtung verschiebbar ist. Bei diesem Ausführungsbeispiel ist außerdem vorgesehen, daß der Halter 17' nicht mit Brücken ausgestattet ist, welche die aufeinanderliegenden Träger 11, 13 umgreifend gegeneinander drücken; sondern mit U-förmigen Brücken 16', deren Schenkel 27' im wesentlichen in einer Ebene bezüglich der Ebene der Träger 11, 13 liegen. Von diesen liegt nun die unkaschierte Seite 25 des flexiblen Trägers 11 auf der mit Leiterbahnen 15 kaschierten Oberfläche 29 des starren Trägers 13. Einschnitte 34 neben den Enden der flexiblen Leiterbahnen 14 machen die benachbart gelegenen Enden der starren Leiterbahnen 15 für die Brücken-Schenkel 27' zugänglich. Die Schenkel 27' liegen also zunächst neben den Enden der flexiblen Leiterbahnen 14 auf der kaschierten Oberfläche 28 des flexiblen Trägers 11 auf und werden dann in Längsrichtung des Halters 17' so weit verschoben, bis jeweils der eine Schenkel 27' eines Paares über das Ende einer flexiblen Leiterbahn 14 zu liegen kommt, während der zugehörige zweite Schenkel 27' das durch den benachbarten Einschnitt 34 hindurch erreichbare Ende der starren Leiterbahn 15 kontaktiert.

Weil beim Ausführungsbeispiel nach Fig. 3 die kontaktgebenden Schenkel 27' der Brücke 16' jeweils in einer Ebene und damit auf derselben Seite der Träger 11, 13 liegen und somit eine Aussparung 31 zum Durchgriff auf die gegenüberliegende Seite nicht erforderlich ist, kann auch auf das Verschieben der Brücke 16' verzichtet werden, indem diese einfach quer zur Ebene der Träger 11, 13 in die Führungsöffnung 21' eingerastet wird. Im Interesse der Kontaktsicherheit ist aber eine Verschiebebewegung der kontaktgebenden freien Schenkelenden relativ zu den Enden der Leiterbahnen 14, 15 und damit eine Verschiebung des Verbinders 12' gegenüber dem Stapel aus den beiden Trägern 11, 13 erforderlich.

Ein exaktes Positionieren der Enden der flexiblen Leiterbahnen 14 bezüglich der starren Leiterbahnen 15 und zugleich eine Sicherung gegen eine Verlagerung beim Bewegen des Halters 17 in die Brücken-Kontaktstellung ist sehr einfach dadurch realisierbar, daß der starre Träger 13 mit einem Einschnitt 35 ausgestattet ist, in den sich der flexible Träger 11 aus der Ebene der Aufnahmeseite 23 für formschlüssige Festlegung eintauchend abwinkeln läßt, wie in Fig. 1/Fig. 2 berücksichtigt.

## Patentansprüche

1. Leiterbahnen-Verbindung zwischen starren Leiterbahnen-Trägern (13) mittels flexibler Leiter, mit einem solchen starren Träger (13) und einem solchen flexiblen Träger (11), wobei die flexiblen Leiter als Leiterbahnen (14) des flexiblen Trägers (11) ausgebildet sind
dadurch gekennzeichnet, daß
der flexible Träger (11) mittels eines relativ zu dem starren Träger (13) wie auch dem flexiblen Träger (11) beweglichen Verbinders (12,12') am starren Träger (13) festlegbar ist, wobei der Verbinder (12, 12') als Halter (17, 17') für eine Kontakt-Brücke (16, 16') ausgelegt ist, daß
der flexible Leiter (11) auf dem starren Träger (13) aufliegt, daß mehr als eine Kontakt-Brücke (16, 16') jeweils U-förmig ausgebildet vorgesehen ist, und daß einer der beiden Schenkel (27, 27') der jeweiligen Kontakt-Brücke (16, 16') mit seinem freien Ende gegen das Ende einer zu verbindenden Leiterbahn (14) des flexiblen Trägers (11) und der andere der beiden Schenkel (27, 27') dieser Kontakt-Brücke (16, 16') mit seinem freien Ende gegen das Ende einer zu verbindenden Leiterbahn (15) des starren Trägers (11) anliegt.

2. Leiterbahnen-Verbindung nach Anspruch 1,
dadurch gekennzeichnet,
daß mehrere Brücken (16) mit ihren Schenkeln (27) radialsternförmig von der Drehachse (20) eines verdrehbaren Halters (17) fortweisen.

3. Leiterbahnen-Verbindung nach Anspruch 1,
dadurch gekennzeichnet,
daß mehrere Brücken (16') in Richtung eines längsverschiebbaren Halters (17') nebeneinander angeordnet sind.

4. Leiterbahnen-Verbindung nach Anspruch 3,
dadurch gekennzeichnet,
daß am längsverschiebbaren Halter (17') mit ihren Schenkeln (27') in entgegengesetzte Richtung weisende Brücken vorgesehen sind.

5. Leiterbahnen-Verbindung nach einem der vorangehenden Ansprüche,
dadurch gekennzeichnet,
daß die Brücken-Schenkel (27, 27') in gegeneinander versetzten Ebenen bezüglich der Leiterbahnen-Träger (11, 13) angeordnet sind und die Träger (11, 13) mit ihren unkaschierten Seiten (23, 25) aufeinanderliegen, wobei neben den übereinanderliegenden Enden der miteinander zu verbindenden Leiterbahnen (14, 15) in den Trägern (11, 13) Aussparungen (31) für den Durchgriff jeweils eines Brücken-Schenkels (27) vorgesehen sind.

6. Leiterbahnen-Verbindung nach einem der Ansprüche 1 bis 4,
dadurch gekennzeichnet,
daß bei im wesentlichen in einer Ebene gelegenen Brücken-Schenkeln (27') die unkaschierte Seite (25) des flexiblen Trägers (11) auf der mit Leiterbahnen (15) kaschierten Oberfläche (29) des starren Trägers (13) ruht und Einschnitte im flexiblen Träger (11) neben seinen Leiterbahnen (14) über den Enden der jeweils zugeordneten starren Leiterbahnen (15) vorgesehen sind.

7. Leiterbahnen-Verbindung nach Anspruch 5,
dadurch gekennzeichnet,
daß der Abstand zwischen den Schenkeln (27) einer U-Brücke (16) sich in Bewegungsrichtung aus den Aussparungen (31) heraus vergrößert.

8. Leiterbahnen-Verbindung nach einem der vorangehenden Ansprüche,
dadurch gekennzeichnet,
daß die Brücken (16, 16') am Halter (17) kraft- oder formschlüssig aber ohne Anwendung von Klebematerialien gehaltert sind.

9. Leiterbahnen-Verbindung nach einem der vorangehenden Ansprüche,
dadurch gekennzeichnet,
daß der flexible Leiterbahnen-Träger (11) eine Polyester-Folie ist.

## Claims

1. A strip conductor connection between rigid strip conductor substrates (13) by means of flexible conductors, having such a rigid substrate (13) and such a flexible substrate (11), whereby the flexible conductors are constructed as strip conductors (14) of the flexible substrate (11),
**characterised in that** the flexible substrate (11) can be fixed on the rigid substrate (13) by means of a connector (12, 12') movable in relation to the rigid substrate (13) and also to the flexible substrate (11), whereby the connector (12, 12') is designed as a support (17, 17') for a contact bridge (16, 16'),
**in that** the flexible conductor (11) lies on the rigid substrate (13),
**in that** more than one contact bridge (16, 16') is provided, in each case constructed in a U shape,
**and in that** one of the two legs (27, 27') of the respective contact bridge (16, 16') lies with its free end towards the end of a strip conductor (14) to be connected of the flexible substrate (11) and the other of the two legs (27, 27') of this contact bridge (16, 16') lies with its free end towards the end of a strip conductor (15) to be connected of the rigid substrate (11).

2. A strip conductor connection according to Claim 1, **characterised in that** several bridges (16) with their legs (27) point away from the axis of rotation (20) of a twistable support (17) in the shape of a radial star.

3. A strip conductor connection according to Claim 1,
**characterised in that** several bridges (16') are disposed next to one another in the direction of a longitudinally displaceable support (17').

4. A strip conductor connection according to Claim 3,
**characterised in that** bridges pointing with their legs (27') in the opposite direction are provided on the longitudinally displaceable support (17').

5. A strip conductor connection according to one of the preceding Claims,
**characterised in that** the bridge legs (27, 27') are disposed in mutually offset planes with respect to the strip conductor substrates (11, 13) and the substrates (11, 13) lie with their uncovered sides (23, 25) on one another, whereby recesses (31) for the engagement of a bridge leg (27) in each case are provided next to the ends, lying one over the other, of the strip conductors (14, 15) to be connected to one another in the substrates (11, 13).

6. A strip conductor connection according to one of Claims 1 to 4,
**characterised in that** in the case of bridge legs (27') laid substantially in one plane, the uncovered side (25) of the flexible substrate (11) rests on the surface (29) of the rigid substrate (13) covered with strip conductors (15) and notches are provided in the flexible substrate (11) next to its strip conductors (14) over the ends of the associated rigid strip conductors (15).

7. A strip conductor connection according to Claim 5,
**characterised in that** the distance between the legs (27)) of a U-shaped bridge increases in the direction of movement away from the recesses (31).

8. A strip conductor connection according to one of the preceding Claims,
**characterised in that** the bridges (16, 16') are mounted on the support (17) in by friction or by form-fit but without the use of adhesive materials.

9. A strip conductor connection according to one of the preceding Claims,
**characterised in that** the flexible strip conductor substrate (11) is a polyester film.

## Revendications

1. Dispositif de raccordement pour bandes conductrices entre des substrats rigides (13) de bandes conductrices au moyen de conducteurs souples, comportant un tel substrat rigide (13) et un tel substrat souple (11), les conducteurs souples étant réalisés sous la forme de bandes conductrices (14) du substrat souple (11) ,
caractérisé
en ce que le substrat souple (11) peut être fixé sur le substrat rigide (13) au moyen d'un dispositif de raccordement (12, 12') mobile par rapport au substrat rigide (13) aussi bien que par rapport au substrat souple (11), le dispositif de raccordement (12, 12') étant conçu en tant que support (17, 17') pour un pont de contact (16, 16'), en ce que le conducteur souple (11) repose sur le substrat rigide (13), en ce que l'on prévoit plus d'un pont de contact (16, 16'), chacun étant en forme de U et en ce que l'une des deux branches (27, 27') de chacun des ponts de contact (16, 16') repose, par son extrémité libre, contre l'extrémité d'une bande conductrice (14) à raccorder du substrat souple (11) et l'autre des deux branches (27, 27') de ce pont de contact (16, 16') repose, par son extrémité libre, contre l'extrémité d'une bande conductrice (15) à raccorder du substrat rigide (13).

2. Dispositif de raccordement pour bandes conductrices selon la revendication 1,
caractérisé
en ce que plusieurs ponts (16) font saillie, par leurs branches (27), en direction radiale et en étoile en s'éloignant de l'axe de rotation (20) d'un support rotatif (17).

3. Dispositif de raccordement pour bandes conductrices selon la revendication 1,
caractérisé
en ce que plusieurs ponts (16') sont disposés les uns à côté des autres selon la direction d'un support (17') pouvant être coulissé longitudinalement.

4. Dispositif de raccordement pour bandes conductrices selon la revendication 3,
caractérisé
en ce que l'on prévoit, sur le support (17') des ponts s'étendant en direction opposée par leurs branches (27').

5. Dispositif de raccordement pour bandes conductrices selon l'une quelconque des revendications précédentes,
caractérisé
en ce que les branches (27, 27') des ponts sont disposées dans des plans décalés les uns par rapport aux autres par rapport aux substrats (11, 13) de bandes conductrices et les substrats (11, 13) sont disposés l'un sur l'autre par leurs faces non imprimées (23, 25), des évidements (31) étant prévus dans les substrats (11, 13) à côté des extrémités reposant l'une sur l'autre des bandes conductrices (14, 15) à raccorder l'une avec l'autre pour l'accrochage, à chaque fois, d'une branche (27) de pont.

6. Dispositif de raccordement pour bandes conductrices selon l'une quelconque des revendications 1 à 4,
caractérisé
en ce que, dans le cas de branche (27') de pont se trouvant essentiellement dans un même plan, la face non imprimée (25) du substrat souple (11) repose sur la surface (29) du substrat rigide (13) imprimée avec les bandes conductrices (15) et des encoches sont prévues dans le substrat souple (11) à côté de ses bandes conductrices (14) au dessus des extrémités de chacune des bandes conductrices (15) rigides adjointe.

7. Dispositif de raccordement pour bandes conductrices selon la revendication 5,
caractérisé
en ce que la distance entre les branches (27) d'un pont en U (16) augmente dans la direction du mouvement à partir des évidements (31).

8. Dispositif de raccordement pour bandes conductrices selon l'une quelconque des revendications précédentes,
caractérisé
en ce que les ponts (16, 16') sont maintenus sur le support (17) par verrouillage de force ou verrouillage de forme, mais sans utilisation de matières adhésives.

9. Dispositif de raccordement pour bandes conductrices selon l'une quelconque des revendications précédentes,
caractérisé
en ce que le substrat souple (11) de bandes conductrices est une feuille de polyester.
